(19) Europäisches Patentamt
European Patent Office
Office européen des brevets

(11) Veröffentlichungsnummer: **0 304 782 B1**

# (12) EUROPÄISCHE PATENTSCHRIFT

(45) Veröffentlichungstag der Patentschrift: **01.12.93**

(51) Int. Cl.$^5$: **C07F 9/48**, C08F 2/50, C08K 5/53, G03F 7/027, G03F 1/02

(21) Anmeldenummer: **88113320.1**

(22) Anmeldetag: **16.08.88**

(54) **Neue 6-Acyl-(6H)-dibenz[c,e] [1,2]oxaphosphorin-6-oxyde, ihre Herstellung und Verwendung als Photoinitiatoren.**

(30) Priorität: **24.08.87 DE 3728169**
**26.05.88 DE 3817860**

(43) Veröffentlichungstag der Anmeldung:
**01.03.89 Patentblatt 89/09**

(45) Bekanntmachung des Hinweises auf die Patenterteilung:
**01.12.93 Patentblatt 93/48**

(84) Benannte Vertragsstaaten:
**AT BE CH DE FR GB IT LI NL**

(56) Entgegenhaltungen:
**EP-A- 0 059 988**
**DE-A- 2 034 887**
**US-A- 3 702 878**

(73) Patentinhaber: **HOECHST AKTIENGESELLSCHAFT**

**D-65926 Frankfurt(DE)**

(72) Erfinder: **Kleiner, Hans-Jerg, Dr.**
**Altkönigstrasse 11a**
**D-6242 Kronberg/Taunus(DE)**
Erfinder: **Gersdorf, Joachim, Dr.**
**Philipp-Holl-Strasse 26**
**D-6200 Wiesbaden(DE)**
Erfinder: **Bastian, Udo, Dr.**
**Backhausfeld 25**
**D-4030 Ratingen 1(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 304 782 B1

## Beschreibung

Die Erfindung betrifft neue 6-Acyl-(6H)-dibenz[c,e][1,2]oxaphosphorin-6-oxyde, ihre Herstellung sowie ihre Verwendung als Photoinitiatoren in photopolymerisierbaren Massen.

Es ist bereits eine Reihe von Photoinitiatoren auf der Basis von Acylphosphinsäureestern und auch Acylphosphanoxyden bekannt (EP-PS 7508). Acylphenylphosphinsäure-phenylester, die den Acyl-(6H)-dibenz[c,e][1,2]oxaphosphorin-6-oxyden strukturmäßig am nächsten kommen, sind in dieser Patentschrift strukturmäßig umfaßt. Über ihre Synthese und physikalischen Daten werden darin jedoch keine Angaben gemacht. Die verwandten Acyl-phenylphosphinsäurealkylester und insbesondere Acyl-diphenylphosphanoxyde können nur über technisch aufwendig herstellbare Zwischenstufen (Dichlor-phenyl-phosphan bzw. Chlor-diphenyl-phosphan) gewonnen werden.

Die Erfindung hat sich nun zum Ziel gesetzt, neue Acyl-Phosphorverbindungen bereitzustellen, die in technisch besonders einfacher Weise herstellbar sind und trotzdem den hohen Anforderungen der Praxis entsprechen.

Gegenstand der Erfindung sind 6-Acyl-(6H)-dibenz[c,e][1,2]oxaphosphorin-6-oxyde der allgemeinen Formel I (s. Formelblatt), worin jeder der Reste $R^1$, $R^2$ und $R^3$ ein- oder mehrfach enthalten sein kann und $R^1$, $R^2$ und $R^3$ Halogen mit einer Ordnungszahl von 9 bis 35, Alkyl oder Alkoxy mit jeweils 1 bis 6, vorzugsweise 1 bis 4 Kohlenstoffatomen und Ar einen aromatischen Kohlenwasserstoffrest mit 6 bis 10 Kohlenstoffatomen bedeuten. Als Alkylgruppen sind Methyl und Äthyl und als Alkoxygruppen Methoxy besonders bevorzugt. In vielen Fällen enthalten die Verbindungen wenigstens ein Chloratom, zweckmäßig jedoch höchstens 2 Chloratome, von denen wiederum zweckmäßig mindestens eines $R^3$ darstellt. Zweckmäßig ist jeder Substituent $R^1$ und $R^2$ nur höchstens einmal vorhanden, insbesondere als $R^1$, und bevorzugt gar nicht vorhanden.

Außer den in den Beispielen genannten Verbindungen der erfindungsgemäßen Stoffe seien beispielsweise das 6-(3-Chlor-benzoyl)- und das 6-(2,6-Dichlor-benzoyl)-(6H)-dibenz[c,e][1,2]oxaphosphorin-6-oxyd genannt, ferner das 6-Benzoyl-(6H)-2- bzw. -4-chlor-, 6-(2- bzw. 3-Methylbenzoyl)-(6H)-2- bzw. -4-chlor-, 6-(2,4- bzw. 2,6- bzw. 3,4- bzw. 3,5-Dimethylbenzoyl)-(6H)-2- bzw. -4-chlor-, das 6-(2,4,6-Trimethylbenzoyl)-4-chlor-, das 6- 2- bzw. 3-Chlorbenzoyl)-(6H)-2- bzw. -4-chlor- und das 6-(2,6-Dimethoxy-benzoyl)-(6H)-2- bzw. -4-chlor-dibenz[c,e][1,2]oxaphosphorin-6-oxyd.

Gegenstand der Erfindung ist auch ein Verfahren zur Herstellung der genannten 6-Acyl-(6H)-dibenz-[c,e][1,2]-oxaphosphorin-6-oxyde, das dadurch gekennzeichnet ist, daß man 6-Alkoxy-(6H)-dibenz[c,e][1,2]-oxaphosphorine der allgemeinen Formel II (s. Formelblatt) mit Acylchloriden der allgemeinen Formel Cl-CO-Ar-$R^3$ (III) umsetzt, worin $R^1$, $R^2$, $R^3$ und Ar die oben angegebene Bedeutung haben und $R^4$ Alkyl, zweckmäßig mit 1 bis 6 C-Atomen, bedeutet. Dabei werden die 6-Acyl-(6H)-dibenz[c,e][1,2]oxaphosphorin-6-oxyde der Formel I in guten Ausbeuten erhalten.

In den Verbindungen der Formel II bedeutet $R^4$ vorzugsweise Methyl oder Äthyl, kann jedoch auch Propyl, Isopropyl oder die verschiedenen Butyl-, Pentyl- und Hexylreste darstellen. Auch die Reste $R^1$ und $R^2$ können außer Methyl und Äthyl bzw. Methoxy und Äthoxy als Alkyl den Propyl-, Isopropyl- oder einen der verschiedenen Butylreste enthalten.

Die Umsetzung kann in Gegenwart oder Abwesenheit eines Katalysators, wie eines tertiären Amins, z.B. Triäthylamin oder Dimethylanilin, und in einem Lösungsmittel, wie einem Kohlenwasserstoff oder Kohlenwasserstoffgemisch wie Petroläther, Toluol, Cyclohexan, einem Äther, wie Dibutyläther oder Tetrahydrofuran, oder anderen üblichen, gegenüber den Reaktionsteilnehmern inerten organischen Lösungsmitteln durchgeführt werden. Bevorzugt ist jedoch die Umsetzung ohne Lösungsmittel.

Die Umsetzung erfolgt zweckmäßig so, daß zu einer Komponente die zweite allmählich zudosiert wird, wobei Alkylchlorid abgespalten wird. Es ist bevorzugt, das Benzoylchlorid vorzulegen. Die Umsetzung erfolgt in der Regel bei Temperaturen von 50 bis 150 °C, bevorzugt von 70 bis 130 °C und insbesondere von 80 bis 120 °C. Die Herstellung erfolgt im allgemeinen bei Atmosphärendruck. Da jedoch Alkylchlorid abgespalten wird, kann es zweckmäßig sein, bei vermindertem Druck zu arbeiten. Dabei ist es bevorzugt, bei der angewandten Reaktionstemperatur einen solchen Druck anzuwenden, daß das Alkylchlorid dampfförmig abgeführt und für sich kondensiert werden kann. Dadurch wird die Aufarbeitung des Reaktionsproduktes erleichtert. Die anfallenden Verbindungen der Formel I werden beispielsweise durch Kristallisation oder Destillation unter vermindertem Druck, insbesondere im Hochvakuum gereinigt.

Die als Ausgangsstoffe verwendeten Verbindungen der allgemeinen Formel II sind z.T. bekannt. Neu sind vor allem die Verbindungen, in denen $R^1$ Halogen, vor allem Chlor, ist. Die bekannten lassen sich glatt aus den entsprechenden 6-Chlor-(6H)-dibenz[c,e][1,2]oxaphosphorinen gewinnen. Ein Syntheseweg dieser Verbindungen der allgemeinen Formel II, der auch auf die neuen Verbindungen anwendbar ist, ist im Formelblatt angegeben. Die Stufen 1 und 2 lassen sich in der Praxis in einem Eintopfverfahren durchführen

und so zusammenfassen. Das Verfahren ist grundsätzlich in der DE-PS 2 034 887 beschrieben. In der Stufe 3 werden dabei tertiäre Amine, wie Triäthylamin, verwendet, und es kann bei Raumtemperatur gearbeitet werden. Es ist klar ersichtlich, daß dieses Verfahren in der Praxis sehr einfach durchzuführen ist. Die erforderliche Knüpfung einer P-C-Bindung unter Bildung einer Aryl-Phosphorverbindung verläuft in einer Weise, die gegenüber den sonst bekannten Verbindungen unvergleichlich einfach ist.

Die erfindungsgemäßen Verbindungen zeigen eine sehr gute Reaktivität als Photoinitiatoren für die Photopolymerisation ungesättigter Verbindungen mit mindestens einer C-C-Mehrfachbindung und Mischungen derselben miteinander und mit Zusatzstoffen. Solche photopolymerisierbaren Gemische, wie sie z.B. zur Herstellung von Formteilen wie Druckplatten und Reliefformen verwendet werden, enthalten als wesentliche Bestandteile mindestens ein Bindemittel, mindestens ein niedermolekulares polymerisierbares Monomeres und mindestens einen Photoinitiator.

Die erfindungsgemäßen Photoinitiatoren müssen mit den Monomeren verträglich und in einem geeigneten Entwicklerlösungsmittel löslich oder dispergierbar sein, um ein Auswaschen der unbelichteten und unvernetzten Anteile einer Schicht der photopolymerisierbaren Aufzeichnungsmassen nach ihrer bildmäßigen Belichtung zu ermöglichen.

Als photopolymerisierbare Monomere eignen sich die üblichen Verbindungen und Stoffe mit polymerisierbaren C-C-Doppelbindungen, die durch z.B. Aryl-, Carbonyl, Amino-, Amid-, Amido-, Ester-, Carboxy- oder Cyanid-Gruppen, Halogenatome oder C-C-Doppel- oder C-C-Dreifachbindungen aktiviert sind. Genannt seien beispielsweise Vinyläther und Vinylester, Styrol, die verschiedenen Vinyltoluole, Acryl- und Methacrylsäure sowie deren Ester mit ein- und/oder mehrwertigen Alkoholen, deren Nitrile oder Amide, Mono- oder Diacrylate bzw. -methacrylate von oligomeren Glykolen bzw. Acryl- und Methacrylsäureester der Reaktionsprodukte von mehrwertigen Alkoholen mit Glykolen, wie Trimethylolpropantriäthoxytriacrylat, Malein- und Fumarester sowie N-Vinylpyrrolidon, N-Vinylcaprolactam, N-Vinylcarbazol und Allylester wie Diallylphthalat.

Die Bindemittel können gesättigt oder ungesättigt sein. Beispielsweise seien genannt lineare Polyamide und besonders alkohollösliche Copolyamide, wie sie in der FR-PS 1 520 856 beschrieben sind, Cellulosederivate, insbesondere wäßrigalkalisch abwaschbare Cellulosederivate, Vinylalkohol-Polymere und Polymere und Copolymere von Vinylestern gesättigter aliphatischer Monocarbonsäuren mit 2 bis 4 C-Atomen, wie Vinylacetat oder Vinylpropionat, mit unterschiedlichem Verseifungsgrad, Polyurethane, Polyätherurethane und Polyesterurethane, und ungesättigte Polyesterharze, wie sie weiter unten beschrieben sind. Geeignet sind ferner oligomere bzw. polymere Epoxyacrylate bzw. -methacrylate, hergestellt aus Acryl- oder Methacrylsäure und aromatischen oder aliphatischen Diglycidyläthern, Urethanacrylate bzw. -methacrylate (z. B. hergestellt aus Hydroxyalkylacrylaten bzw. -methacrylaten und Polyisocyanaten), sowie Polyesteracrylate bzw. -methacrylate (z. B. hergestellt aus hydroxylgruppenhaltigen gesättigten Polyestern und Acryl- oder Methacrylsäure), Polyätheracrylate bzw. -methacrylate, hergestellt aus Diolen aliphatischer oder aromatischer Natur und Acryl- bzw. Methacylsäure, Aminacrylate bzw. -methacrylate und Melaminacrylate bzw. -methacrylate (z. B. hergestellt aus Methylolderivaten der Amine bzw. des Melamins und Acryl-bzw. Methacrylsäure).

Geeignet sind ferner elastomere Blockcopolymerisate, die wenigstens zwei thermoplastische nicht-elastomere Polymerblöcke mit einer Einfriertemperatur über 25 °C und zwischen den nicht-elastomeren Polymerblöcken einen elastomeren Polymerblock mit einer Einfriertemperatur von unter 10 °C enthalten. Beispielsweise seien Polystyrol-Polyisopren- Polystyrol-Blockcopolymerisate genannt, wie sie in der US-PS 3 265 725 beschrieben sind. Anstelle der Styrolkomponenten können auch Polymere von Homologen und Analogen des Styrols, wie $\alpha$-Methylstyrol und der verschiedenen Vinyltoluole verwendet werden.

Gegebenenfalls können die photopolymerisierbaren Massen auch als wäßrige Dispersionen vorliegen oder zur Anwendung gebracht werden.

Den photopolymerisierbaren Massen, deren Zusammensetzung für den jeweiligen Verwendungszweck dem Fachmann geläufig ist, können in an sich bekannter Weise gesättigte und/oder ungesättigte Polymere sowie weitere Zusatzstoffe wie Inhibitoren gegen die thermische Polymerisation, Paraffin, Pigmente, Farbstoffe, Peroxide, Verlaufshilfsmittel, Füllstoffe, Mattierungsmittel und Glasfasern sowie Stabilisatoren gegen thermischen oder photochemischen Abbau zugesetzt sein. Art und Menge der Zusätze hängen vom jeweiligen Verwendungszweck ab.

Die erfindungsgemäßen Verbindungen werden im allgemeinen in einer Konzentration von 0,001 bis 20, zweckmäßig von 0,01 bis 15 bzw. 10 %, vorzugsweise von 0,1 bis 5 %, bezogen auf das Gewicht der photopolymerisierbaren Masse, eingesetzt. Sie können gegebenenfalls mit Beschleunigern kombiniert werden, die den hemmenden Einfluß des Luftsauerstoffs auf die Photopolymerisation beseitigen. Solche Beschleuniger bzw. Synergisten sind vor allem tertiäre Amine wie Methyldiäthanolamin, Dimethyläthanolamin, Triäthylamin, Triäthanolamin, p-Dimethylamino-benzoesäure-äthylester, Benzyl-dimethylamin, Dimethylaminoäthylacrylat, N-Methyl-N-phenylglycin und analoge, dem Fachmann bekannte Verbindungen. Zur

Beschleunigung der Aushärtung können weiterhin aliphatische und/oder aromatische Halogenverbindungen dienen wie 2-Chlormethylnaphthalin, 1-Chlor-2-chlormethylnaphthalin, sowie Radikalbildner wie Peroxide und Azo-Verbindungen.

Nach einer weiterhin vorteilhaften Ausführungsform können die erfindungsgemäßen Verbindungen in Kombination mit anderen Photoinitiatoren in allen Gewichtsverhältnissen, zweckmäßig von 0,5:1 bis 30:1, vorzugsweise von 0,8:1 bis 10:1 und insbesondere von 1:1 bis 3:1 eingesetzt werden. Derartige geeignete Initiatoren sind z.B. aromatische Ketone und deren funktionelle Derivate, wie Ketale, z.B. Benzildimethylketal, 2-Hydroxy-2-methyl-1-phenylpropan-1-on, Diäthoxyacetophenon, Benzophenon sowie Derivate vom Thioxanthon oder Gemische aus diesen. Der Gesamtgehalt an diesen Kombinationen liegt im allgemeinen zwischen 1 und 20 %, bezogen auf das Gewicht der gesamten polymerisierbaren Masse.

Ein besonderer Vorteil dieser Photoinitiatorkombinationen ist, daß hierdurch eine deutliche Erhöhung der Aushärtungsgeschwindigkeit und eine bessere Härte der ausgehärteten Filme erzielt wird. Ein weiterer Vorteil der Photoinitiatorkombinationen ist, daß die für die Herstellung strahlenhärtbarer Massen entstehenden Kosten, die durch die phosphororganischen Verbindungen verursacht werden, deutlich verringert werden.

Ein weiterer, gänzlich unerwarteter Vorteil der vorgenannten Kombinationen der bekannten und erfindungsgemäßen Photoinitiatoren ist, daß auch pigmentierte Systeme in Schichtstärken von weit über 100 µm ausgehärtet werden können.

Die Aushärtungsgeschwindigkeit kann durch die Zugabe sekundärer und/oder tertiärer Aminoverbindungen zusätzlich erhöht werden. Geeignet sind z.B. Triäthylamin, Benzylmethylamin, Benzyldimethylamin oder solche mit aliphatischen Hydroxylgruppen wie Diäthanolamin, N-Methyl-diäthanolamin, Phenyldiäthanolamin und die anderen, weitere oben genannten tertiären Aminoverbindungen bzw. deren Gemische.

Die erfindungsgemäßen Photoinitiatoren können mit den bekannten in der Weise kombiniert werden, daß der entsprechende Emissionsbereich der UV-Strahler voll dem Absorptionsbereich der Initiatorkombination entspricht (z.B. 300-420 nm oder 200-420 nm).

Die erfindungsgemäßen Aufzeichnungsmassen bestehen überwiegend, d.h. zu mehr als 50 und bevorzugt zu 70 bis 100 Gew.-% aus der Photoinitiator enthaltenden Mischung aus Monomeren und Bindemittel. Der Gehalt dieser Mischung an polymerem Bindemittel beträgt im allgemeinen etwa 45 bis 90 und insbesondere 45 bis 65 Gew.-%, bezogen auf die Summe der Mengen an Monomeren und Bindemittel.

Die Verarbeitung der photopolymerisierbaren Aufzeichnungsmassen zu Photopolymerdruckplatten kann in üblicher Weise erfolgen und ist davon abhängig, ob die Masse flüssig oder fest ist. Sie erfolgt durch bildmäßiges Belichten, z.B. mit aktinischem Licht. Danach werden für die Herstellung von Reliefdruckformen oder Photoresists die nichtbelichteten Anteile der Schicht der Aufzeichnungsmassen in üblicher Art mechanisch entfernt oder mit einem geeigneten Entwicklungslösungsmittel ausgewaschen und die resultierenden Formen getrocknet, in manchen Fällen auch noch voll nachbelichtet.

Von besonderem Vorteil ist, daß es mit den Aufzeichnungsmassen oft möglich ist, sogar auf eine Vorbelichtung vor der bildmäßigen Belichtung von Schichten dieser photopolymerisierbaren Aufzeichnungsmassen zu verzichten, wobei dennoch mit guten Belichtungszeiten gearbeitet werden kann. Ein unerwarteter großer Vorteil ist ferner, daß Schichten der erfindungsgemäßen Aufzeichnungsmassen bei ihrer Verarbeitung zu Reliefdruckformen verbesserte Reliefstrukturen ergeben, was z.B. beim Druck zu einer deutlich verbesserten Wiedergabe von Negativschriften führt.

Als Strahlungsquellen für das die Polymerisation solcher Mischungen auslösende Licht verwendet man vorteilhaft solche, die Licht hauptsächlich im Absorptionsbereich der erfindungsgemäßen Verbindungen aussenden, d.h. zwischen 200 oder 300 und 450 nm. Besonders geeignet sind Quecksilber-Niederdruckstrahler, -Mitteldruck- und -Hochdruckstrahler, sowie (superaktinische) Leuchtstoffröhren oder Impulsstrahler. Die genannten Lampen können gegebenenfalls dotiert sein.

**Herstellungsbeispiele**

**1. 6-Benzoyl-(6H)-dibenz[c,e][1,2]oxaphosphorin-6-oxid**

56 g (0,399 Mol) Benzoylchlorid wurden unter Stickstoffatmosphäre auf 80 bis 85 °C erwärmt. Unter Rühren wurden 92 g (0,4 Mol) 6-Methoxy-(6H)-dibenz[c,e][1,2]oxaphosphorin innerhalb von 90 Minuten eingetropft. Dann wurde die Temperatur schrittweise bis auf 130 °C erhöht. Es wurde bei dieser Temperatur gehalten, bis keine Entwicklung von Methylchlorid mehr zu erkennen war. Der Rückstand wurde bei Raumtemperatur mit 70 ml Toluol digeriert. Man erhielt 116 g (90 % der Theorie) der oben genannten Verbindung, die nach einer schnellen Umkristallisation aus Äthanol einen Fp. von 134 bis 135 °C hatte.

| | | | | |
|---|---|---|---|---|
| $C_{19}H_{13}O_3P$ (320) | ber. gef. | 71,25 % C 71,2 % C | 4,06 % H 4,1 % H | 9,69 % P 9,5 % P |

**2. 6-(2-Methyl-benzoyl)-(6H)-dibenz[c,e][1,2]-oxaphosphorin-6-oxid**

61,8 g (0,4 Mol) 2-Methylbenzoylchlorid wurden unter Stickstoffatmosphäre auf 80 °C erwärmt. Unter Rühren wurden 92 g (0,4 Mol) 6-Methoxy-(6H)-dibenz[c,e][1,2]-oxaphosphorin während zwei bis drei Stunden zugetropft. Dann wurde die Temperatur schrittweise auf 115 °C erhöht. Nach beendeter Reaktion wurden bei Raumtemperatur 50 ml Aceton zugefügt. Nach dem Auskristallisieren erhielt man 103 g (77% der Theorie) der obengenannten Verbindung vom Fp. 102 bis 104 °C.

| | | | | |
|---|---|---|---|---|
| $C_{20}H_{15}O_3P$ (334) | ber. gef. | 71,86%C 71,8 %C | 4,49%H 4,42%H | 9,28%P 9,1 %P |

**3. 6-(3-Methyl-benzoyl)-(6H)-dibenz[c,e][1,2]-oxaphosphorin-6-oxid**

46,6 g (0,3 Mol) 3-Methylbenzoylchlorid wurden unter Stickstoffatmosphäre auf 85 °C erwärmt. Unter Rühren wurden 69 g (0,3 Mol) 6-Methoxy-(6H)-dibenz[c,e][1,2]-oxaphosphorin zugetropft. Dann wurde die Temperatur schrittweise bis 115 °C gesteigert. Nach beendeter Reaktion wurden bei Raumtemperatur 50 ml Toluol zugefügt. Nach dem Auskristallisieren erhielt man 85 g (84% der Theorie) der obengenannten Verbindung vom Fp. 108 bis 111 °C.

| | | | | |
|---|---|---|---|---|
| $C_{20}H_{15}O_3P$ (334) | ber. gef. | 71,86%C 71,9 %C | 4,49%H 4,4 %H | 9,28%P 9,2 %P |

**4. 6-(4-Methyl-benzoyl)-(6H)-dibenz[c,e][1,2]-oxaphosphorin-6-oxid**

30,8 g (0,2 Mol) 4-Methylbenzoylchlorid wurden unter Stickstoffatmosphäre auf 80 °C erwärmt. Unter Rühren wurden 46 g (0,2 Mol) 6-Methoxy-(6H)-dibenz[c,e][1,2]oxaphosphorin in einer Stunde zugetropft. Dann wurde die Temperatur langsam auf 110 °C erhöht. Nach beendeter Umsetzung kristallisierte der Rückstand bei Raumtemperatur langsam aus. Man erhielt 60 g (90% der Theorie) der obengenannten Verbindung, die nach Umkristallisation aus Toluol einen Fp. von 124 bis 125 °C hatte.

| | | | | |
|---|---|---|---|---|
| $C_{20}H_{15}O_3P$ (334) | ber. gef. | 71,86 % C 71,0 % C | 4,49 % H 4,6 % H | 9,28 % P 9,0 % P |

**5. 6-(4-Tert.-butyl-benzoyl)-(6H)-dibenz[c,e][1,2]-oxaphosphorin-6-oxid.**

39,2 g (0,2 Mol) 4-tert.-Butyl-benzoylchlorid wurden unter Stickstoffatmosphäre auf 80 °C erwärmt. Unter Rühren wurden 46 g (0,2 Mol) 6-Methoxy-(6H)-dibenz[c,e][1,2]-oxaphosphorin zugetropft. Die Temperatur wurde dann allmählich auf 120 °C erhöht. Nach beendeter Reaktion wurden 45 ml Toluol hinzugefügt. Bei Raumtemperatur kristallisierte das Produkt. Man erhielt 52 g (70% der Theorie) der obengenannten Verbindung mit einem Fp. 151 bis 155 °C.

| | | | | |
|---|---|---|---|---|
| $C_{23}H_{21}O_3P$ (376) | ber. gef. | 73,40%C 73,4 %C | 5,59%H 5,6 %H | 8,25%P 8,1 %P |

**6. 6-(2,4-Dimethyl-benzoyl)-(6H)-dibenz[c,e][1,2]-oxaphosphorin-6-oxid**

33,7 g (0,2 Mol) 2,4-Dimethylbenzoylchlorid wurden unter Stickstoffatmosphäre auf 80 °C erwärmt. Unter Rühren wurden 46 g (0,2 Mol) 6-Methoxy-(6H)-dibenz[c,e][1,2]oxaphosphorin zugetropft. Der Ansatz begann dabei bereits zu kristallisieren. Daraufhin wurde die Temperatur langsam auf 135 °C erhöht mit der Maßgabe, daß bei 90 °C Toluol als Verdünnungsmittel zugefügt wurde. Aus dem Kristallisat erhielt man nach Digerieren mit Toluol 58 g (83 % der Theorie) der obengenannten Verbindung vom Fp. 166 °C.

| | | | | |
|---|---|---|---|---|
| $C_{21}H_{17}O_3P$ | ber. | 72,41 % C | 4,89 % H | 8,91 % P |
| (348) | gef. | 72,3 % C | 4,7 %H | 8,8 % P |

**7. 6-(2,6-Dimethylbenzoyl)-(6H)-dibenz[c,e][1,2]-oxaphosphorin-6-oxid**

16,85 g (0,1 Mol) 2,6-Dimethylbenzoylchlorid wurden unter Stickstoffatmosphäre auf 80 °C erwärmt. Unter Rühren wurden 23 g (0,1 Mol) 6-Methoxy-(6H)-dibenz[c,e][1,2]oxaphosphorin zugetropft. Die Temperatur wurde langsam bis auf 122 °C erhöht. Es wurde bei dieser Temperatur gehalten, bis kein Entweichen von Methylchlorid mehr zu erkennen war. Nach dem Abkühlen wurden 30 ml Toluol zugegeben. Nach dem Auskristallisieren erhielt man 22,5 g (65 % der Theorie) der obengenannten Verbindung, die einen Fp. von 128 bis 130 °C hatte.

| | | | | |
|---|---|---|---|---|
| $C_{21}H_{17}O_3P$ | ber. | 72,41 % C | 4,89 % H | 8,91 % P |
| (348) | gef. | 72,3 % C | 4,7 % H | 8,8 % P |

**8. 6-(3,4-Dimethyl-benzoyl)-(6H)-dibenz[c,e][1,2]-oxaphosphorin-6-oxid**

50,6 g (0,3 Mol) 3,4-Dimethylbenzoylchlorid wurden unter Stickstoffatmosphäre auf 80 °C erwärmt. Unter Rühren wurden 69 g (0,3 Mol) 6-Methoxy-(6H)-dibenz[c,e][1,2]oxaphosphorin zugetropft. Im Laufe des Zutropfens begann bereits die Auskristallisation, die Temperatur wurde deshalb auf 100 °C erhöht; gleichzeitig wurden zusätzlich 100 ml Toluol zugetropft. Nach beendetem Zutropfen wurde zum Rückfluß erhitzt. Nach beendeter Umsetzung und nach dem Auskristallisieren erhielt man 87 g (83 % der Theorie) der obengenannten Verbindung, die einen Fp. von 160 bis 162 °C hatte.

| | | | | |
|---|---|---|---|---|
| $C_{21}H_{17}O_3P$ | ber. | 72,41%C | 4,89%H | 8,91%P |
| (348) | gef. | 72,46%C | 4,8 %H | 8,8 %P |

**9. 6-(3,5-Dimethyl-benzoyl)-(6H)-dibenz[c,e][1,2]-oxaphosphorin-6-oxid**

67,4 g (0,4 Mol) 3,5-Dimethylbenzoylchlorid wurden unter Stickstoffatmosphäre auf 80 °C erwärmt. Unter Rühren wurden 92 g (0,4 Mol) 6-Methoxy-(6H)-dibenz[c,e][1,2]-oxaphosphorin während zwei Stunden zugetropft. Die Temperatur wurde dabei schrittweise bis 115 °C erhöht. Nach beendeter Reaktion wurden bei Raumtemperatur 50 ml Aceton hinzugefügt. Nach dem Auskristallisieren erhielt man 113 g (81 % der Theorie) der oben genannten Verbindung vom Fp. 120 bis 124 °C.

| | | | | |
|---|---|---|---|---|
| $C_{21}H_{17}O_3P$ | ber. | 72,41%C | 4,89%H | 8,91%P |
| (348) | gef. | 72,3 %C | 4,8 %H | 8,9 %P |

**10. 6-(2,4,6-Trimethyl-benzoyl)-(6H)-dibenz[c,e][1,2]-oxaphosphorin-6-oxid**

18,25 g (0,1 Mol) 2,4,6-Trimethylbenzoylchlorid wurden unter Stickstoffatmosphäre auf 85 °C erwärmt. Unter Rühren wurden 23 g (0,1 Mol) 6-Methoxy-(6H)-dibenz[c,e][1,2]-oxaphosphorin eingetropft. Die Temperatur wurde langsam bis auf 105 ° C erhöht. Es wurde bei dieser Temperatur gehalten, bis kein Entweichen von Methylchlorid mehr zu erkennen war. Nach beendeter Umsetzung wurde Toluol zugegeben. Nach dem Auskristallisieren erhielt man 27 g (75 % der Theorie) der obengenannten Verbindung vom Fp. 109 ° C.

| | | | | |
|---|---|---|---|---|
| $C_{22}H_{15}O_3P$ (362) | ber. gef. | 72,93 % C 72,7 % C | 5,25 % H 5,3 % H | 8,56 % P 8,3 % P |

**11. 6-(3-Methoxy-benzoyl)-(6H)-dibenz[c,e][1,2]-oxaphosphorin-6-oxid**

42,6 g (0,25 Mol) 3-Methoxybenzoylchlorid wurden unter Stickstoffatmosphäre auf 70 ° C erwärmt. Unter Rühren wurden 57,5 g (0,25 Mol) 6-Methoxy-(6H)-dibenz[c,e][1,2]-oxaphosphorin zugetropft. Dann wurde die Temperatur langsam auf 120 ° C erhöht. Es wurde bei dieser Temperatur gehalten, bis kein Entweichen von Methylchlorid mehr zu erkennen war. Nach dem Abkühlen auf 90 ° C wurden 90 ml Toluol zugegeben. Nach dem Auskristallisieren erhielt man 65 g (75% der Theorie) der obengenannten Verbindung vom Fp. 116 bis 118 ° C.

| | | | | |
|---|---|---|---|---|
| $C_{20}H_{15}O_4P$ (350) | ber. gef. | 68,57%C 68,5 %C | 4,29%H 4,3 %H | 8,86%P 8,7 %P |

**12. 6-(2,4-Dimethoxy-benzoyl)-(6H)-dibenz[c,e][1,2]-oxaphosphorin-6-oxid**

35,1 g (0,175 Mol) 2,4-Dimethoxybenzoylchlorid wurden unter Stickstoffatmosphäre auf 70 ° C erwärmt. Unter Rühren wurden 40,3 g (0,175 Mol) 6-Methoxy-(6H)-dibenz[c,e][1,2]-oxaphosphorin während zwei Stunden zugetropft. Dann wurde die Temperatur langsam auf 110 ° C erhöht. Es wurde bei dieser Temperatur gehalten, bis kein Entweichen von Methylchlorid mehr zu erkennen war. Nach dem Abkühlen auf 60 ° C wurden 70 ml Toluol zugegeben. Nach dem Auskristallisieren erhielt man 50 g (75% der Theorie) der obengenannten Verbindung vom Fp. 112 bis 115 ° C.

| | | | | |
|---|---|---|---|---|
| $C_{21}H_{17}O_5P$ (380) | ber. gef. | 66,32%C 66,3 %C | 4,47%H 4,2 %H | 8,16%P 8,0 %P |

**13. 6-(3,5-Dimethoxy-benzoyl)-(6H)-dibenz[c,e][1,2]-oxaphosphorin-6-oxid**

35,1 g (0,175 Mol) 3,5-Dimethoxy-benzoylchlorid wurden unter Stickstoffatmosphäre auf 80 ° C erwärmt. Unter Rühren wurden 40,3 g (0,175 Mol) 6-Methoxy-(6H)-dibenz[c,e][1,2]-oxaphosphorin während einer Stunde zugetropft. Gleichzeitig wurde allmählich die Temperatur auf 115 ° C erhöht. Nach beendeter Umsetzung wurden bei 80 ° C 60 ml Toluol hinzugefügt. Nach dem Auskristallisieren erhielt man 49 g (74% der Theorie) der oben genannten Verbindung vom Fp. 140 bis 142 ° C.

| | | | | |
|---|---|---|---|---|
| $C_{21}H_{17}O_5P$ (380) | ber. gef. | 66,32%C 66,2 %C | 4,47%H 4,5 %H | 8,16%P 8,1 %P |

**14. 6-(2,6-Dimethoxy-benzoyl)-(6H)-dibenz[c,e][1,2]-oxaphosphorin-6-oxid**

60,1 g (0,3 Mol) 2,6-Dimethoxybenzoylchlorid wurden unter Stickstoffatmosphäre auf 85 ° C erwärmt. Dann wurden 69 g (0,3 Mol) 6-Methoxy-(6H)-dibenz[c,e][1,2]oxaphosphorin unter Rühren zugetropft. Dann wurde die Temperatur langsam auf 125 ° C erhöht. Nach beendeter Reaktion und Abkühlen wurden 150 ml Toluol zugegeben. Nach dem Auskristallisieren erhielt man 99 g (87% der Theorie) der obengenannten Verbindung vom Fp. 96 bis 98 ° C.

| | | | | |
|---|---|---|---|---|
| $C_{21}H_{17}O_5P$ (380) | ber. gef. | 66,32%C 66,1 %C | 4,47%H 4,4 %H | 8,16%P 8,2 %P |

**15. 6-(3,4,5-Trimethoxy-benzoyl)-(6H)-dibenz[c,e][1,2]-oxaphosphorin-6-oxid**

35,6g (0,154 Mol) 3,4,5-Trimethoxybenzoylchlorid wurden unter Stickstoffatmosphäre auf 100°C erwärmt. Dann wurden 35,5 g (0,154 Mol) 6-Methoxy-(6H)-dibenz[c,e][1,2]-oxaphosphorin unter Rühren zugetropft und die Temperatur danach auf 115°C erhöht. Nach beendeter Reaktion wurden bei 90°C 70 ml Toluol zugegeben und dann weiter abgekühlt. Nach dem Auskristallisieren erhielt man 44 g (70% der Theorie) der obengenannten Verbindung vom Fp. 147 bis 149°C.

| | | | | |
|---|---|---|---|---|
| $C_{22}H_{19}O_6P$ (410) | ber. gef. | 64,39%C 64,2 %C | 4,63%H 4,4 %H | 7,56%P 7,4 %P |

**16. 6-(2-Chlorbenzoyl)-(6H)-dibenz[c,e][1,2]-oxaphosphorin-6-oxid**

52,5 g (0,3 Mol) 2-Chlorbenzoylchlorid wurden unter Stickstoffatmosphäre auf 80°C erwärmt. Nun wurden unter Rühren 69 g (0,3 Mol) 6-Methoxy-(6H)-dibenz[c,e][1,2]-oxaphosphorin zugetropft. Während des Zutropfens wurde auf 60°C abgekühlt, dann die Temperatur bei 60-70°C gelassen. Nach beendeter Umsetzung wurden bei 45°C 40 ml Toluol zugesetzt. Man erhielt 92 g (89% der Theorie) der obengenannten Verbindung vom Fp. 108 bis 110°C.

| | | | | | |
|---|---|---|---|---|---|
| $C_{19}H_{12}ClO_3P$ (354,5) | ber. gef. | 64,32%C 64,2 %C | 3,39%H 3,4 %H | 10,1%Cl 9,9%Cl | 8,75%P 8,6 %P |

**17. 6-(4-Chlorbenzoyl)-(6H)-dibenz[c,e][1,2]oxaphosphorin-6-oxid**

35 g (0,2 Mol) 4-Chlorbenzoylchlorid wurden unter Stickstoffatmosphäre auf 90 bis 100°C erwärmt. Nun wurden unter Rühren 46 g 6-Methoxy-(6H)-dibenz[c,e][1,2]-oxaphosphorin eingetropft. Die Innentemperatur wurde dann allmählich auf 130°C erhöht. Nach beendeter Umsetzung wurde mit 50 ml Toluol digeriert. Man erhielt 60 g (85 % der Theorie) der obengenannten Substanz vom Fp. 125 bis 131°C.

| | | | | | |
|---|---|---|---|---|---|
| $C_{19}H_{12}ClO_3P$ (354,5) | ber. gef. | 64,32% C 64,1 % C | 3,39% H 3,3 % H | 10,1% Cl 9,7% Cl | 8,75% P 8,4 % P |

**18. 6-(2-Naphthoyl)-(6H)-dibenz[c,e,][1,2]-oxaphosphorin-6-oxid**

50 g (0,262 Mol) 2-Naphthoylchlorid wurden unter Stickstoffatmosphäre auf 80°C erwärmt. Unter Rühren wurden 60,3 g (0,262 Mol) 6-Methoxy-(6H)-dibenz[c,e][1,2]-oxaphosphorin in zwei Stunden eingetropft. Anschließend wurde die Innentemperatur allmählich auf 125°C erhöht. Nach beendeter Reaktion wurden 110 ml Toluol zugesetzt. Nach Auskristallisation erhielt man 87 g (90 % der Theorie) der obengenannten Verbindung vom Fp. 151 bis 153°C.

| | | | | |
|---|---|---|---|---|
| $C_{23}H_{15}O_3P$ (370) | ber. gef. | 74,59%C 74,5 %C | 4,05%H 4,0 %H | 8,38%P 8,2 %P |

**19. 6-(1-Naphthoyl)-(6H)-dibenz[c,e][1,2]-oxaphosphorin-6-oxid**

50 g (0,262 Mol) 1-Naphthoylchlorid wurden unter Stickstoffatmosphäre auf 80 bis 85 °C erwärmt. Unter Rühren wurden 60,3 g (0,262 Mol) 6-Methoxy-(6H)-dibenz[c,e][1,2]-oxaphosphorineingetropft. Die Reaktion verlief exotherm. Die Temperatur wurde dann schrittweise bis 125 °C erhöht. Nach beendeter Reaktion wurden bei 40 °C 90 ml Toluol hinzugefügt. Nach Auskristallisation erhielt man 77 g (80 % der Theorie) der obengenannten Verbindung vom Fp. 149 bis 151 °C.

| | | | | |
|---|---|---|---|---|
| $C_{23}H_{15}O_3P$ (370) | ber.<br>gef. | 74,59%C<br>74,4 %C | 4,05%H<br>4,0 %H | 8,38%P<br>8,1 %P |

**20. 6-(1-(2-Methylnaphthoyl))-(6H)-dibenz[c,e][1,2]-oxaphosphorin-6-oxid**

96,7 g (0,473 Mol) 1-(2-Methylnaphthoyl)chlorid wurden unter Stickstoffatmosphäre auf 85 °C erwärmt. Unter Rühren wurden 109 g (0,473 Mol) 6-Methoxy-(6H)-dibenz[c,e][1,2]-oxaphosphorin in 2 bis 3 Stunden eingetropft. Anschließend wurde die Innentemperatur allmählich auf 120 °C erhöht. Nach beendeter Umsetzung wurden nach Abkühlung auf 50 °C 100 ml Toluol zugesetzt. Nach Auskristallisation erhielt man 142 g (78 % der Theorie) der oben genannten Verbindung, die nach Umkristallisation aus Toluol einen Fp. von 155-156 °C hatte.

| | | | | |
|---|---|---|---|---|
| $C_{24}H_{17}O_3P$ (384) | ber.<br>gef. | 75,00 % C<br>74,9 % C | 4,43 % H<br>4,4 % H | 8,07 % P<br>8,0 % P |

**21. 6-(4-Methyl-benzoyl)-(6H)-2-chlor-dibenz[c,e][1,2]-oxaphosphorin-6-oxid**

a) Herstellung des 6-Methoxy-(6H)-2-chlor-dibenz-[c,e][1,2]-oxaphosphorins über drei Stufen

**1. Stufe: Dichlor-(2-phenyl-4-chlor-phenoxy)-phosphan**

79,5 g (0,389 Mol) 2-Phenyl-4-chlor-phenol wurden mit 65,7 g (0,478 Mol) Phosphortrichlorid langsam bis auf 150 °C erhitzt. Gleichzeitig entwich Chlorwasserstoff. Nach beendeter Reaktion wurde bei 0,027 kPa destilliert. Bei einer Temperatur von 145 bis 146 °C gingen 80 g (67 % der Theorie, bezogen auf eingesetztes 2-Phenyl-4-chlor-phenol) der vorgenannten Substanz über (s. Formelblatt, Formel V mit $R^1$ = 2-Chlor und $R^2$ = H)

| | | | | | |
|---|---|---|---|---|---|
| $C_{12}H_8Cl_3OP$ (305,5) | ber.<br>gef. | 47,14% C<br>47,0 % C | 2,62% H<br>2,6 % H | 34,86% Cl<br>34,3 % Cl | 10,15% P<br>9,6 % P |

**2. Stufe: 6-Chlor-(6H)-2-chlor-dibenz[c,e][1,2]-oxaphosphorin**

165 g (0,54 Mol) Dichlor-(2-phenyl-4-chlor-phenoxy)-phosphan und 1,1 g wasserfreies Zinkchlorid wurden auf 150 °C erwärmt; danach wurde die Temperatur schrittweise bis auf 250 °C erhöht. Es wurde bei dieser Temperatur gehalten, bis kein Chlorwasserstoffgas mehr entwich. Nach beendeter Umsetzung wurde bei 0,027 kPa destilliert. Bei 160 °C gingen 105 g (72,5 % der Theorie) der obengenannten Substanz der Formel VI (s. Formelblatt mit $R^1$ = 2-Chlor und $R^2$ = Wasserstoff) vom Erstarrungspunkt 40,5 °C über.

| | | | | | |
|---|---|---|---|---|---|
| $C_{12}H_7Cl_2OP$ (269) | ber.<br>gef. | 53,53% C<br>53,3 % C | 2,60% H<br>2,9 % H | 26,39% Cl<br>25,5 % Cl | 11,52% P<br>11,5 % P |

**3. Stufe: 6-Methoxy-(6H)-2-chlor-dibenz[c,e][1,2]-oxaphosphorin**

94 g (0,349 Mol) 6-Chlor-(6H)-2-chlor-dibenz[c,e][1,2]-oxaphosphorin wurden bei 70 °C in 40 ml Toluol gelöst. Diese Lösung wurde aus einem beheizten Tropftrichter zu einem Gemisch von 11,2 g (0,349 Mol) abs. Methanol, 35,4 g (0,349 Mol) Triäthylamin und 150 ml abs. Toluol bei 20 °C unter Kühlen innerhalb von 90 Minuten unter lebhaftem Rühren eingetropft. Es wurde bei dieser Temperatur noch 4 Stunden gerührt; dann wurde vom Triäthylaminhydrochlorid abgesaugt und dieses mit Toluol nachgewaschen. Das Filtrat wurde im Vakuum der Wasserstrahlpumpe vom Toluol befreit und dann bei 0,027 kPa destilliert. Bei 170 °C gingen 72 g (78 % der Theorie) der obengenannten Verbindung der Formel II (s. Formelblatt mit $R^1$ = 2-Chlor, $R^2$ = Wasserstoff und $R^4$ = Methyl) vom Fp. 46 bis 49 °C über.

| | | | | | |
|---|---|---|---|---|---|
| $C_{13}H_{10}ClO_2P$ | ber. | 58,98% C | 3,78% H | 13,42% Cl | 11,72% P |
| (264,5) | gef. | 58,9 % C | 3,8 % H | 13,3 % Cl | 11,4 % P |

**b) Erfindungsgemäße Umsetzung**

17,8 g (0,115 Mol) 4-Methylbenzoylchlorid wurden unter Stickstoffatmosphäre auf 100 °C erhitzt. Unter Rühren wurden 30,4 g (0,115 Mol) 6-Methoxy-(6H)-2-chlor-dibenz[c,e][1,2]oxaphosphorin aus einem beheizten Tropftrichter zugetropft. Die Temperatur wurde allmählich auf 115 °C erhöht. Es wurde bei dieser Temperatur gehalten, bis kein Methylchlorid mehr entwich. Der Rückstand wurde nach beendeter Umsetzung mit 15-20 ml Toluol digeriert. Man erhielt 36 g (85 % der Theorie) der oben genannten Verbindung vom Fp. 144 bis 148 °C.

| | | | | | |
|---|---|---|---|---|---|
| $C_{20}H_{14}ClO_3P$ | ber. | 65,13% C | 3,80% H | 9,63% Cl | 8,41% P |
| (368,5) | gef. | 65,3 % C | 3,9 % H | 9,1 % Cl | 7,6 % P |

**22. 6-(2,4,6-Trimethyl-benzoyl)-(6H)-2-chlor-dibenz-[c,e][1,2]oxaphosphorin-6-oxid**

22,8 g (0,125 Mol) 2,4,6-Trimethylbenzoylchlorid wurden unter Stickstoffatmosphäre auf 100 °C erhitzt. Unter Rühren wurden 33,1 g (0,125 Mol) 6-Methoxy-(6H)-2-chlor-dibenz[c,e][1,2]oxaphosphorin eingetropft. Die Temperatur wurde langsam bis auf 120 °C erhöht. Es wurde bei dieser Temperatur gehalten, bis kein Methylchlorid mehr entwich. Der Rückstand wurde nach dem Erkalten mit Aceton digeriert. Man erhielt 30 g (60 % der Theorie) der oben genannten Verbindung vom Fp. 145 bis 146 °C.

| | | | | | |
|---|---|---|---|---|---|
| $C_{22}H_{18}ClO_3P$ | ber. | 66,58% C | 4,54% H | 8,95% Cl | 7,82% P |
| (396,5) | gef. | 66,6 % C | 4,4 % H | 8,8 % Cl | 7,6 % P |

**23. 6-(4-Chlor-benzoyl)-(6H)-2-chlor-dibenz[c,e][1,2]-oxaphosphorin-6-oxid**

16,1 g (0,092 Mol) 4-Chlorbenzoylchlorid wurden unter Stickstoffatmosphäre auf 90 °C erwärmt. Unter Rühren wurden 24,4 g (0,092 Mol) 6-Methoxy-(6H)-2-chlor-dibenz[c,e][1,2]-oxaphosphorin aus einem beheizten Tropftrichter zugetropft. Die Temperatur wurde allmählich auf 140 °C erhöht. Es wurde bei dieser Temperatur gehalten, bis kein Methylchlorid mehr entwich. Der Rückstand wurde nach dem Erkalten mit 20 ml Toluol digeriert. Man erhielt 27 g (75 % der Theorie) der oben genannten Verbindung vom Fp. 183 bis 185 °C.

| | | | | |
|---|---|---|---|---|
| $C_{19}H_{11}Cl_2O_3P$ | ber. | 58,61 % C | 2,83 % H | 7,97 % P |
| (389) | gef. | 58,6 % C | 2,8 % H | 7,6 % P |

**Anwendungsbeispiele**

24. Eine Lösung von 91,2 g eines Styrol-Isopren-Styrol-Dreiblockcopolymeren mit 15 % Styrolgehalt, 8 g Hexandiol-1,6-diacrylat, 0,5 g 6-(2,4,6-Trimethyl-benzoyl)-(6H)-dibenz-[c,e][1,2]-oxaphosphorin-6-oxid und 0,3 g 2,6-Di-tert.-butyl-4-methylphenol in 100 g Toluol wurde auf eine 125 µm dicke, biaxial verstreckte und thermofixierte Polyesterfolie (Polyäthylenterephthalat) unter Verwendung eines Metallrahmens zu einer 6 mm dicken Schicht gegossen. Nach Verdunsten des Toluols wurde auf die freie Oberfläche der 3 mm dicken Photopolymerschicht eine mit einer Haftschicht versehene 125 µm dicke, biaxial verstreckte und thermofixierte Polyesterfolie (Polyäthylenterephthalat) aufgelegt und das Mehrschichtenelement in einer Plattenpresse bei 110 °C unter Verwendung von 2,8 mm dicken Distanzstücken 5 Minuten gepreßt. Nach dem Abstreifen der unbeschichteten Polyesterfolie wurde die Photopolymerschicht mit einem handelsüblichen UV-Flachbelichter (emittierter Wellenlängenbereich 320-400 nm; Intensität des UV-Streulichtes 14 $mW/cm^2$) 220 Sekunden durch die verbliebene Polyesterfolie und danach 15 Minuten bildmäßig von der freien Schichtseite aus belichtet. Nach dem Auswaschen der nichtbelichteten Bildstellen mit Tetrachloräthan wurde eine elastische Hochdruckform mit guter Reliefausbildung (Relieftiefe 1,0 mm) und einer Härte von 63° Shore-A erhalten.

25. 145,5 g eines copolymeren, innerlich weichgemachten Polyvinylalkohols (®Mowiol 04/MI der Hoechst AG) wurden durch Rühren in 147 g Wasser bei 90 °C gelöst. Nach Abkühlen auf 70 °C wurden unter Rühren 90 g 2-Hydroxyäthylmethacrylat, 10 g Trimethylolpropantriacrylat, 5 g 6-(2,4,6-Trimethylbenzoyl)-(6H)-dibenz-[c,e][1,2]-oxaphosphorin-6-oxid und 1 g 2,6-Ditert.butyl-4-methylphenol zugegeben. Die homogene viskose Lösung wurde auf eine 125 µm Dicke Polyesterfolie (Polyäthylenterephthalat) schichtförmig so aufgetragen, daß nach 48-stündigem Trocknen bei Raumtemperatur eine ca. 1,2 mm dicke, nicht klebende lichtempfindliche Schicht resultierte. Auf die freie Schichtoberfläche wurde ein mit einem Polyurethan-Haftlack gemäß DE-OS 15 97 515 versehenes 0,3 mm dickes Aluminiumblech aufgelegt und das Mehrschichtelement in einer Plattenpresse bei 120 °C unter Verwendung von 0,6 mm dicken Distanzstücken 5 Minuten gepreßt. Nach dem Abstreifen der unbeschichteten Polyesterfolie wurde die lichtempfindliche Schicht bildmäßig 5 Minuten mit einem handelsüblichen UV-Flachbelichter (emittierter Wellenbereich 320 bis 400 nm; Intensität des UV-Streulichtes 10 $mW/cm^2$) belichtet. Nach dem Auswaschen der nichtbelichteten Bildstellen mit warmen Wasser wurde eine Hochdruckform mit guter Reliefausbildung und einer Härte von 90° Shore-A erhalten.

**26. Photopolymer-Flexodruckplatten**

Eine Lösung von 91 g eines Styrol-Isopren-Styrol-Dreiblockcopolymeren mit 15 % Styrolgehalt, 8 g Hexandiol-1,6-diacrylat, 0,3 g 2,6-Di-tert.-butyl-4-methylphenol und 1 g 6-(2,4,6-Trimethylbenzoyl)-(6H)-dibenz-[c,e][1,2]oxaphosphorin-6-oxid (Versuch A) bzw. 1 g 2,4,6-Trimethylbenzoyl-diphenylphosphanoxid (Vergleichsversuch V 26.1) in 100 g Toluol, wurde auf eine 125 µm dicke, biaxial verstreckte und thermofixierte Polyesterfolie (Polyäthylenterephthalat) unter Verwendung eines Metallrahmens zu einer 6 mm dicken Schicht gegossen. Nach Verdunsten des Toluols wurde die 3 mm dicke Photopolymerschicht zwischen zwei 125 µm dicken, biaxial verstreckten und thermofixierten Polyesterfolien (Polyäthylenterephthalat) unter Verwendung von 2,8 mm dicken Distanzstücken in einer Plattenpresse 5 Minuten bei 110 °C gepreßt. Nach dem Abstreifen der Polyesterfolien wurde die Photopolymerschicht mit einem handelsüblichen UV-Flachbelichter (emittierter Wellenlängenbereich 320-400 nm, Intensität des UV-Streulichtes 14 $mW/cm^2$) von jeder Seite 30 Minuten lang belichtet. Die Härte betrug je 65° Shore-A für Versuch A und V 26.1, das Elastizitätsmodul (150 mm lange und 15 mm breite Probenstreifen, Einspannlänge 100 mm) 6,5 $N/mm^2$ bei Versuch A und 5,2 $N/mm^2$ bei V 26.1 (jeweils Mittelwert von 5 Messungen, Standardabweichung ± 0,3 $N/mm^2$). Die Bestimmung des Abtriebs nach DIN 53 516 ergab für Versuch A 170,0 ± 5,4 mg und für V 26.1 213,4 ± 6,3 mg (jeweils Mittelwert und Standardabweichung von 5 Messungen).

Mit der erfindungsgemäßen Verbindung werden also bei gleicher Shore-A-Härte ein größeres E-Modul und eine eindeutig größere Abriebfestigkeit im Vergleich zu de Verbindung gemäß V 26.1 erhalten. Die Abriebfestigkeit ist ein Maß für die zu erwartende Auflagenfestigkeit entsprechender Druckplatten beim Druckprozeß.

**27. und 28. Photopolymer-Flachdruckplatten**

27. Eine Lösung von 3,92 g eines Copolymeren aus Methylmethacrylat und Methacrylsäure mit dem mittleren Molekulargewicht 35 000 und der Säurezahl 86, 3,92 g Trimethylolpropantriacrylat, 0,107 g 6-(1-Naphthoyl)-(6H)-dibenz[c,e][1,2]-oxaphosphorin-6-oxid, 0,084 g des Azofarbstoffs aus 2,4-Dinitro-6-chlor-benzoldiazoniumsalz und 2-Methoxy-5-acetylamino-N-cyanoäthyl-N-hydroxyäthylanilin und 0,07 g 4-Dimethylamino-4′-methyldibenzalaceton in 51,4 ml 2-Butanon wurde gerührt, filtriert und auf einer Plattenschleuder auf elektrolytisch aufgerauhtes und anodisiertes Aluminium aufgeschleudert. Die Platten wurden 2 Minuten bei 90 °C getrocknet; das Schichtgewicht betrug 3,5 g/m$^2$. Nach Aufbringen einer Deckschicht wurde die Photopolymerschicht unter einer kombinierten Negativvorlage, bestehend aus einem Halbton-Stufenkeil, Strichelementen und 60er und 120er Punktrasterelementen mit einem 8 kW-Xenon-Kopiergerät belichtet. Die belichtete Platte wurde 1 Minute mit einem Entwickler aus 3 Gewichtsteilen Natriummetasilikat x 9 $H_2O$, 0,03 Gewichtsteilen Kokosfettamin-Äthylenoxid-Reaktionsprodukt und 96,97 Gewichtsteilen vollentsalztem Wasser entwickelt. Dann wurde mit 1 %iger Phosphorsäure fixiert und abschließend mit schwarzer Fettfarbe eingefärbt. Es wurde eine Flachdruckplatte mit guter Auflösung der Bildstellen erhalten.

28. Beispiel 27 wurde in der Weise abgewandelt, daß statt 0,107 g 6-(1-Naphthoyl)-(6H)-dibenz[c,e]-[1,2]-oxaphosphorin-6-oxid nunmehr 0,21 g 6-(1-(2-Methylnaphthoyl))-(6H)-dibenz-[c,e][1,2]-oxaphosphorin-6-oxid verwendet und auf den Zusatz des 4-Dimethylamino-4′-methyldibenzalacetons verzichtet wurde. Man erhielt ebenfalls eine Flachdruckplatte mit guter Auflösung der Bildstellen.

29. Trocken-Photoresistplatte

Eine Lösung von 27,5 g eines Terpolymeren aus n-Hexylmethacrylat, Methacrylsäure und Styrol (60:30:10) mit einem mittleren Molekulargewicht von 35000 und der Säurezahl 195, 18,3 g Trimethylolpropantriacrylat, 0,92 g 6-(1-(2-Methylnaphthoyl))-(6H)-dibenz[c,e][1,2]-oxaphosphorin-6-oxid und 0,05 g des Azofarbstoffs aus 2,4-Dinitro-6-chlor-benzoldiazoniumsalz und 2-Methoxy-5-acetylamino-N-cyanoäthyl-N-hydroxyäthylanilin in 92,8 ml Butanon und 2 ml Äthanol wurde auf eine biaxial verstreckte und thermofixierte Polyäthylenterephthalatfolie der Stärke 25 µm so aufgeschleudert, daß nach dem Trocknen bei 110 °C eine Schichtdicke von 35 µm erhalten wurde. Man erhielt eine Trockenresistfolie, die mit einer handelsüblichen Laminiervorrichtung bei 120 °C auf eine mit 35 µm starker Kupferfolie kaschierte Phenoplast-Schichtstoffplatte laminiert und 90 Sekunden mit einem 8 kW-Xenon-Kopiergerät bildmäßig belichtet wurde. Als Vorlage diente eine Strichvorlage mit Linienbreiten und Abständen bis herab zu 80 µm. Nach der Belichtung wurde die Polyesterfolie abgezogen und die Schicht durch Besprühen mit einer 1 %igen Natriumcarbonatlösung innerhalb 2 Minuten entwickelt. Die Platte wurde dann in eine 15 %ige Ammoniumperoxydisulfatlösung von 50 °C getaucht. Die den unbelichteten Teilen der Schicht entsprechenden Kupferflächen wurden weggeätzt, und die zurückbleibende belichtete Schicht wurde mit Trichloräthan entfernt, wonach ein einwandfreies negatives Kupferbild der ursprünglichen Bildvorlage erhalten wurde.

**30.-47. Pigmentierte UV-Dickschichtvergußmassen**

Es wurden verschiedene pigmentierte Dickschichtvergußmassen auf der Basis einer Kombination von Epoxyacrylaten folgender Zusammensetzung untersucht:

| | |
|---|---|
| a) Epoxyacrylat-Präpolymeres | 77,5 Gew.-Teile |
| b) Tripropylenglykoldiacrylat | 2,5 " " |
| c) Dipropylenglykoldiacrylat | 20,0 " " |
| d) Pigment | 0,1-5 " " |
| e) Photoinitiatorgemisch | 5,0 " " |

Die Epoxyacrylat-Präpolymer-Komponente bestand aus einer Kombination von 4 verschiedenen Typen, und zwar ®Roskydal LS 2812 (Säurezahl höchstens 5, OH-Zahl höchstens 300, Viskosität 300 PA•s) der Fa. Bayer AG, Leverkusen, Deutschland, ®Setacure AP 569 (Säurezahl höchstens 5, Viskosität 100-150 Pa•s) der Firma Synthese-Chemie, Bergen op Zoom, Niederlande, ®Ebecryl 600 (Aromatisches Bisphenol-A-Acrylat, Säurezahl höchstens 8, Molekulargewicht 500, Viskosität 4000-8000 mPa•s) und Ebecryl 170 PA, beide von der Firma UCB in Drogenbos, Belgien im Gewichtsverhältnis von 40:20:10:7,5. Die ersten drei Typen stellen neutrale Epoxyacrylat-Präpolymere dar. Das Ebecryl 170 PA ist ein carboxylgruppenhaltiges Präpolymeres. Als Pigmente wurden verschiedene Produkte wie ®Heliogen-Blau (BASF AG, Ludwigshafen, Deutschland), Ruß, Titandioxyd, Eisenoxyd, ®Hostaperm-Gelb, Hostaperm-Scharlach GO eingesetzt.

Das Photoinitiatorgemisch bestand aus gleichen Teilen 2-Hydroxy-2-methylpropiophenon und einem Acylphosphanoxyd, und zwar den einzelnen, in den Beispielen 2 bis 4, 6, 8 bis 17, 19 und 21 bis 23 aufgeführten Stoffen.

Die pigmentierten Dickschichtvergußmassen wurden auf einem Aluminiumsubstrat in Schichtstärken von 100 - 5000 µm aufgetragen. Die Aushärtung erfolgte unter einer Hg-Hochdrucklampe (80 W/cm) je nach Schichtdicke und Pigment in 5-10 Minuten. Es entstanden Vergußmassen mit brillanter Oberfläche, guter Haftung und hoher Chemikalienbeständigkeit.

### 48. Hochpigmentierte UV-Decklacke

In der in den Beispielen 30-47 genannten Rezeptur kann der Pigmentanteil auf 30-60 % erhöht werden. Die hierbei entstehenden Lacke wurden mit Schichtdicken von 5-100 µm aufgetragen und auf einer UV-Durchlaufanlage mit Hg-Hochdrucklampen (2 x 20 cm - 100 W/cm) bei einer Durchlaufgeschwindigkeit zwischen 1 und 10 m/min, die je nach der Schichtdicke und der Art des Pigmentes eingestellt wurde, ausgehärtet. Die Anwendung erfolgte durch Rakeln bzw. Walzen. Durch Zugabe von Lösungsmitteln (Einstellung auf etwa 70 % Festkörpergehalt) konnte das Lackmaterial auch spritztechnisch verarbeitet werden, z.B. zur Herstellung von Beschichtungen auf Glas, Polyesterfolien, verschiedenen Metallsubstraten usw.

### 49.-66. Hochpigmentierte UV-Lacke für Tampondruck- bzw. Siebdruckverfahren

Es wurden pigmentierte Lacke zur Tampondruck- bzw. Siebdruckanwendung, bestehend aus

| | | | |
|---|---|---|---|
| a) Epoxyacrylat-Präpolymerem (Roskydal LS 2812) | 35,0 | Gew.-Teile | |
| b) Hexandioldiacrylat | 16,0 | " | " |
| c) Titandioxyd | 50,0 | " | " |
| d) Photoinitiatorkombination (wie in den Beispielen 30 bis 47) | 5,0 | " | " |

untersucht. Die Lackfilme wurden in einer UV-Durchlaufanlage bei 1-15 m/min Durchlaufgeschwindigkeit, die je nach der Schichtdicke und der Art des Pigmentes eingestellt wurde, durch 2 Hg-Hochdruckstrahler(2 x 20 cm - 100 W/cm) ausgehärtet.

Die Anwendung erfolgte z.B. zum Bedrucken von Polyesterfolien Polycarbonat, verschiedenen Metallsubstraten usw.

### 67.-84. Hochpigmentierte und klare UV-Mattlacke

Es wurden Lacke auf der Basis einer ewas anderen Kombination von Epoxyacrylaten untersucht, als sie den Beispielen 30 bis 47 zugrunde lag. Das Lacksystem bestand aus

| | | | |
|---|---|---|---|
| a) Epoxyacrylat-Präpolymerem | 72,5 | Gew.-Teile | |
| b) Tripropylenglykoldiacrylat | 7,5 | " | " |
| c) Dipropylenglykoldiacrylat | 20,0 | " | " |
| d) Mattierer | 5,0 | " | " |
| e) Pigment (wie in den Beispielen 30-47) | 10,0 | " | " |
| f) Photoinitiatorkombination (wie in den Beispielen 30 bis 47) | 5,0 | " | " |

Die Epoxyacrylat-Präpolymer-Komponente bestand aus einer Kombination von Roskydal LS 2812, Setacure AP 569, Ebecryl 170 PA und Ebecryl 600 im Gewichtsverhältnis von 40:20:10:2,5. Als Mattierer wurde ®Pergopak M, ein Harnstoff-Formaldehyd-Kondensationsprodukt, der Fa. Martinswerk GmbH,

Bergheim/Erft, Deutschland verwendet.

Mit diesem Lacksystem wurden Glasoberflächen und Polyesterfolien beschichtet und auf einer UV-Durchlaufanlage bei einer Durchlaufgeschwindigkeit von 5-10 m/min, wiederum in Abhängigkeit von der Art des Pigments und der Schichtdicke ausgehärtet (2 Hg-Hochdruckstrahler à 20 cm Länge; 100 W/cm).

85.-102. UV-Spachtelmassen

Es wurden hochgefüllte, UV-härtbare, styrolfreie Spachtelmassen, die z.B. für die Autoreparatur geeignet sind, auf der Basis folgender Rezeptur untersucht:

| | | | |
|---|---|---|---|
| a) Epoxyacrylat-Präpolymeres | 36,25 | Gew.-Teile | |
| b) Tripropylenglykoldiacrylat | 3,75 | " | " |
| c) Dipropylenglykoldiacrylat | 10,0 | " | " |
| d) Aktive Kieselsäure ((R)Aerosil 300) | 1,0 | " | " |
| e) Eisenoxyd ((R)Bayferrox 316) | 0,07 | " | " |
| f) Titandioxyd | 2,1 | " | " |
| g) Talkum (Finntalc M 40) | 38,5 | " | " |
| h) Photoinitiatorkombination (wie in den Beispielen 30 bis 47) | 4,5 | " | " |

Die Epoxyacrylat-Präpolymer-Komponente bestand aus Roskydal LS 2812, Setacure AP 570 (Säurezahl höchstens 4, Viskosität 80-120 Pa•s), Ebecryl 170 PA und Ebecryl 600 im Gewichtsverhältnis von 20:10:5:1,25.

Die Massen wurden auf Metall aufgetragen und mit Hg-Hochdrucklampen (400 W) 10-15 min gehärtet. Nach der UV-Härtung können die Beschichtungen sowohl naß als auch trocken geschliffen werden.

**103. UV-Klarlacke**

In der in den Beispielen 85 bis 102 genannten Rezeptur wurden die Pigmente (Komponenten d) bis g)) weggelassen und so Klarlacke hergestellt. Man beobachtete eine deutliche Erhöhung der Aushärtegeschwindigkeit und der Härte der Uberzüge.

**104.-107. Pigmentierte Lacke für Holzwerkstoffe und Möbel**

Es wurde ein Gemisch der Photoinitiatoren 6-(2,4-6-Trimethyl-benzoyl)-(6H)-dibenz[c,e][1,2]-oxaphosphorin-6-oxid (Beispiel 10) und 2-Hydroxy-2-methyl-1-phenylpropan-1-on in verschiedenen Kunstharzen geprüft. Dazu wurde das Produkt des Beispiels 10 am heißen Wasserbad (80-90 °C) in dem 2-Hydroxy-2-methyl-1-phenylpropan-1-on zu einer 50 %igen Lösung gelöst. Diese Lösung blieb während der Verarbeitungszeit von einigen Tagen bei 20-25 ° C klar.

Sodann wurden Versuchslacke aus folgenden Komponenten hergestellt:

| | |
|---|---|
| Kunstharz | 76,5 Gewichtsteile |
| ®Bayertitan RKB 3 (Pigment) | 9,0 " |
| Tripropylenglykoldiacrylat | 10,0 " |
| Initiatormischung | 4,5 " |

Als Kunstharze wurden solche der Vianova Kunstharz AG, Werndorf bei Graz, Österreich, eingesetzt, und zwar in

Beispiel 104 ein Epoxy-Acrylat (Viaktin VTE 5940),

Beispiel 105 ein Epoxy-Acrylat (Viaktin VTE 5286),

Beispiel 106 ein Melamin-Acrylat (Viaktin VTE 5956),

Beispiel 107 ein ungesättigter Polyester (Viapal UP 586 E).

Viaktin VTE 5940 ist ein UV-härtbares, vorsensibilisiertes acrylmodifiziertes Epoxidharz, 80 % in Hexandiol-1,6-diacrylat, der dynamischen Viskosität/25 °C von 7000 - 11000 mPa•s, der Farbzahl nach DIN 6162 unter 7 und der Säurezahl nach DIN 53402 unter 17. Viaktin VTE 5286 ist ein elektronenstrahlhärtbares, acrylmodifiziertes Epoxidharz, 80 % in Hexandiol-1,6-diacrylat, das die gleichen Kennzahlen hat wie Viaktin VTE 5940. Viaktin VTE 5956 ist ein nicht UV-vorsensibilisiertes, 100 %iges Melaminacrylat der dynamischen Viskosität/25 °C von 400 - 2000 mPa•s und der Farbzahl nach DIN 6162 von höchstens 1. Viapal UP 586 U ist ein photopolymerisierbares ungesättigtes Glanzpolyesterharz, 67 %ig in Styrol mit der dynamischen Viskosität/20 °C von 750 - 1000 mPa•s, der Farbzahl nach DIN 6162 unter 2 und der Säurezahl nach DIN 53402 unter 30.

Die Lacke wurden mit einer Handrakel

a) auf Glas zu Schichtdicken von 30 µm und 60 µm und

b) für die Prüfung auf die Erichsentiefung auf Original-Erichsen-Bleche zu Schichtdicken von 30 µm und 60 µm

aufgezogen. Die Härtung erfolgte durch Bestrahlung mit einem UV-Hochdruckstrahler (Lampenleistung 80 Watt/cm) bei einer Vorschubgeschwindigkeit von 0,5 m/min.

Die Filme wurden dann auf die Pendeldämpfung nach Persoz nach der französischen Norm NFT 30016, die Erichsentiefung nach DIN 53156 und die Chemikalienfestigkeit geprüft. Zu der letztgenannten Prüfung wurden sie je 5 min a) einem Gemisch von gleichen Gewichtsteilen Äthanol und Wasser, b) Aceton, c) Methyläthylketon (MEK) und d) gleichen Gewichtsteilen Isopropanol und Wasser sowie 30 min lang Wasser ausgesetzt. Die Ergebnisse sind in folgender Tabelle zusammengestellt. Man ersieht daraus, daß eine gute Härtung erfolgte.

**Ergebnisse (Meßdaten):**

| Beispiel | Pendelhärte nach Persoz | | Erichsen-Tiefung | | Chemikalientests 30 µm | | | | |
|---|---|---|---|---|---|---|---|---|---|
| | 30µm | 60µm | 30µm | 60µm | Äthanol 50%ig | Aceton | MEK | Isoprop. 50 %ig | Wasser |
| 104 | 298 | 243 | 1,7 | 1,3 | i.O. | i.O. | i.O. | i.O. | i.O. |
| 105 | 307 | 305 | 1,5 | 1,3 | i.O. | i.O. | i.O. | i.O. | i.O. |
| 106 | 329 | 308 | 1,2 | 0,9 | i.O. | i.O. | i.O. | i.O. | i.O. |
| 107 | 240 | 229 | 3,2 | 2,0 | i.O. | i.O. | i.O. | i.O. | i.O. |

Formelblatt

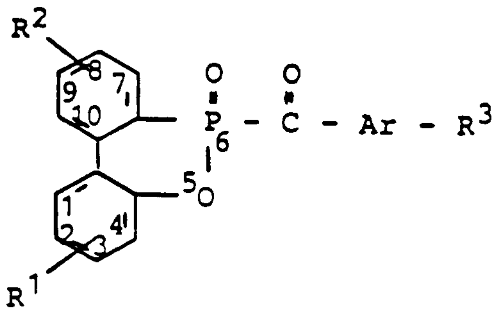

(I)

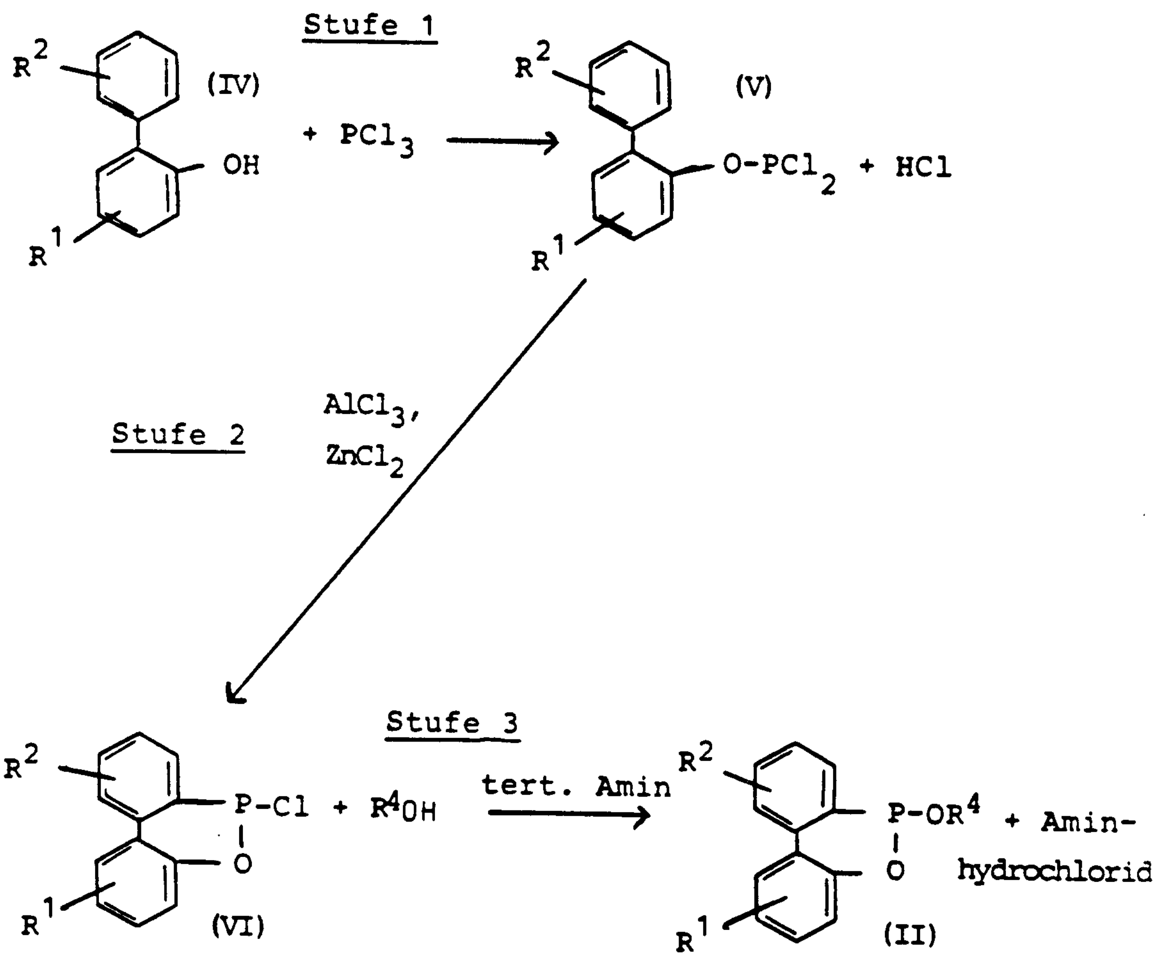


## Patentansprüche

**1.** 6-Acyl-(6H)-dibenz[c,e][1,2]oxaphosphorin-6-oxyde der Formel I

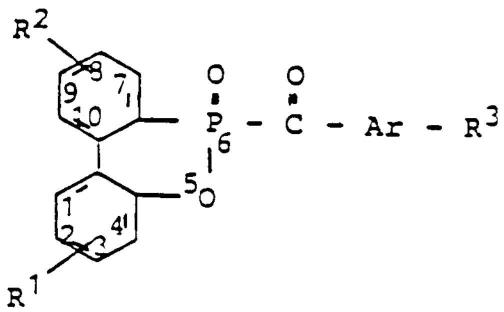

(I)

worin jeder der Reste $R^1$, $R^2$ und $R^3$ ein- oder mehrfach enthalten sein kann und $R^1$, $R^2$ und $R^3$ Halogen mit einer Ordnungszahl von 9 bis 35, Alkyl oder Alkoxy mit jeweils 1 bis 6 Kohlenstoffatomen und Ar einen aromatischen Kohlenwasserstoffrest mit 6 bis 10 Kohlenstoffatomen bedeuten.

**2.** Verbindungen nach Anspruch 1, gekennzeichnet durch wenigstens eines der Merkmale, daß
a) wenigstens einer der Reste $R^1$, $R^2$ und $R^3$ Chlor ist, wobei vorzugsweise $R^1$, $R^2$ und $R^3$ zusammen höchstens zwei Chloratome enthalten, von denen mindestens eines $R^3$ darstellt,
b) Alkyl- bzw. Alkoxygruppen jeweils 1 bis 4 Kohlenstoffatome enthalten, wobei vorzugsweise Alkyl für Methyl oder Athyl und Alkoxy für Methoxy steht,
c) sie nur höchstens je einen Rest $R^1$ und $R^2$ und vorzugsweise keine Reste $R^1$ und $R^2$ enthalten, und
d) sie wenigstens einen Rest $R^3$, vorzugsweise in Form eines oder zweier ortho-ständiger Reste und daneben gegebenenfalls noch eines Restes in para-Stellung enthalten.

**3.** Verbindungen nach Anspruch 1 oder 2, dadurch gekennzeichnet, daß Ar den Benzolring darstellt.

**4.** Verfahren zur Herstellung von Verbindungen nach einem oder mehreren der Ansprüche 1 bis 3, dadurch gekennzeichnet, daß man eine Verbindung der Formel II

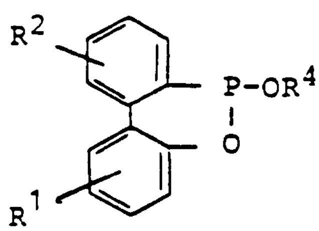

(II)

mit einem Acylchlorid der Formel Cl-CO-Ar-$R^3$ (III) umsetzt, wobei $R^1$, $R^2$, $R^3$ und Ar die in den Ansprüchen 1 bis 3 angegebene Bedeutung haben und $R^4$ Alkyl, zweckmäßig mit 1 bis 6 C-Atomen und vorzugsweise Methyl oder Äthyl, bedeutet.

**5.** Verfahren nach Anspruch 4, dadurch gekennzeichnet, daß man bei Temperaturen von 50 bis 150 °C, vorzugsweise von 70 bis 130 °C und insbesondere von 80 bis 120 °C arbeitet.

**6.** Verwendung von Verbindungen gemäß einem oder mehreren der Ansprüche 1 bis 3 oder solchen, die nach dem Verfahren gemäß Anspruch 4 oder 5 erhalten worden sind, als Photoinitiatoren in polymerisierbaren Massen.

**7.** Ausführungsform nach Anspruch 6, dadurch gekennzeichnet, daß die Verbindungen in einer Menge von 0,001 bis 20, zweckmäßig von 0,01 bis 15 und vorzugsweise von 0,1 bis 5 %, bezogen auf das Gewicht der photopolymerisierbaren Masse, zugegen sind.

**8.** Ausführungsform nach Anspruch 7 oder 8, dadurch gekennzeichnet, daß die polymerisierbaren Massen in Form von strahlenhärtbaren Beschichtungen, insbesondere Klarlacken oder pigmentierten Lacken oder Druckfarben, oder Verguß-, Spachtel- oder Dichtungsmassen vorliegen, die die Verbindungen

gemäß Anspruch 1 in einer Konzentration von 0,001 bis 20, vorzugsweise von 0,01 bis 10 Gew.-% enthalten.

**9.** Ausführungsform nach Anspruch 7, 8 oder 9, dadurch gekennzeichnet, daß die Verbindungen gemäß Anspruch 1 in Kombination mit anderen Photoinitiatoren, insbesondere aromatischen Ketonen und/oder Thioxanthon-Derivaten verwendet werden, zweckmäßig in Gewichtsverhältnis von 0,5:1 bis 30:1, vorzugsweise von 0,8:1 bis 10:1 und insbesondere von 1:1 bis 3:1, wobei der Gesamtgehalt an Photoinitiatoren zweckmäßig zwischen 1 und 20 %, bezogen auf das Gewicht der gesamten polymerisierbaren Masse, liegt.

**10.** Ausführungsform nach Anspruch 9, dadurch gekennzeichnet, daß als Beschleuniger noch wenigstens eine sekundäre und/oder tertiäre Aminoverbindung mitverwendet wird.

**11.** 6-Alkoxy-(6H)-dibenz[c,e][1,2]oxaphosphorine der Formel II

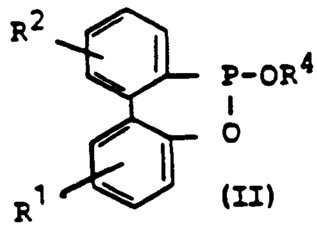

(II)

(II)

worin $R^1$ und $R^2$ die in den Ansprüchen 1 bis 3 angegebene Bedeutung haben und $R^4$ Alkyl mit 1 bis 6 C-Atomen bedeutet, wobei jedoch mindestens ein $R^1$ Halogen ist.

## Claims

**1.** A6-acyl-(6H)-dibenz[c,e][1,2]oxaphosphorine 6-oxide of the formula I

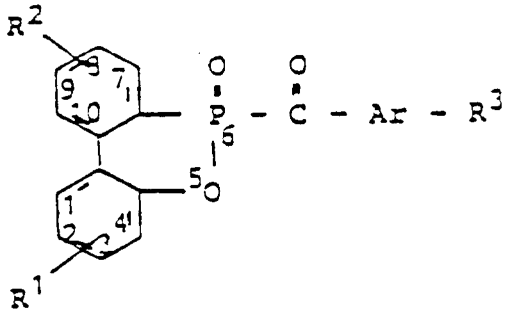

(I)

in which each of the radicals $R^1$, $R^2$ and $R^3$ may be present one or more times, and $R^1$, $R^2$ and $R^3$ are halogen having an atomic number of from 9 to 35, or alkyl or alkoxy, in each case having 1 to 6 carbon atoms, and Ar is an aromatic hydrocarbon radical having 6 to 10 carbon atoms.

**2.** A compound as claimed in claim 1, having at least one of the features that

a) at least one of the radicals $R^1$, $R^2$ and $R^3$ is chlorine, where $R^1$, $R^2$ and $R^3$ together preferably contain at most 2 chlorine atoms, of which at least one is $R^3$,

b) alkyl and alkoxy groups each contain 1 to 4 carbon atoms, where alkyl is preferably methyl or ethyl and alkoxy is preferably methoxy,

c) it contains at most only one each of the radicals $R^1$ and $R^2$ and preferably contains no radicals $R^1$ and $R^2$, and

d) it contains at least one radical $R^3$, preferably in the form of one or two radicals in the ortho-position and in addition, if desired, one radical in the para-position.

**3.** A compound as claimed in claim 1 or 2, wherein Ar is the benzene ring.

**4.** A process for the preparation of a compound as claimed in one or more of claims 1 to 3, which comprises reacting a compound of the formula II

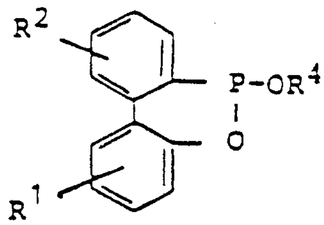

(II)

with an acyl chloride of the formula Cl-CO-Ar-$R^3$ (III), where $R^1$, $R^2$, $R^3$ and Ar are as defined in claims 1 to 3, and $R^4$ is alkyl, expediently having 1 to 6 carbon atoms, and is preferably methyl or ethyl.

**5.** The process as claimed in claim 4, which is carried out at temperatures of from 50 to 150 ° C, preferably of from 70 to 130 ° C and in particular of from 80 to 120 ° C.

**6.** The use of a compound as claimed in one or more of claims 1 to 3 or obtained by the process as claimed in claim 4 or 5 as a photoinitiator in polymerizable compositions.

**7.** The embodiment as claimed in claim 6, wherein the compound is present in an amount of from 0.001 to 20 %, expediently from 0.01 to 15 % and preferably from 0.1 to 5 %, based on the weight of the photopolymerizable composition.

**8.** The embodiment as claimed in claim 7 or 8, wherein the polymerizable compositions are in the form of radiation-curable coatings, in particular varnishes or pigmented paints or printing inks, or encapsulation compounds, knifing fillers or sealants, which contain the compounds as claimed in claim 1 in a concentration of from 0.001 to 20 % by weight, preferably from 0.01 to 10 % by weight.

**9.** The embodiment as claimed in claim 7, 8 or 9, wherein the compound as claimed in claim 1 is used in combination with other photoinitiators, in particular aromatic ketones and/or thioxanthone derivatives, expediently in a ratio by weight of from 0.5:1 to 30:1, preferably from 0.8:1 to 10:1 and in particular from 1:1 to 3:1, where the total content of photoinitiators is expediently between 1 and 20 %, based on the weight of the total polymerizable composition.

**10.** The embodiment as claimed in claim 9, wherein, as accelerator, at least one secondary and/or tertiary amino compound is also used.

**11.** A 6-alkoxy-(6H)-dibenz[c,e][1,2]oxaphosphorine of the formula II

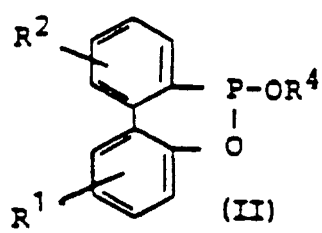

(II)

(II)

in which $R^1$ and $R^2$ are as defined in claims 1 to 3, and $R^4$ is alkyl having 1 to 6 carbon atoms, but where at least one $R^1$ is halogen.

## Revendications

**1.** Oxydes d'acyl-6 (6H)-dibenzo[c,e][1,2]oxaphosphorine-6 de formule I

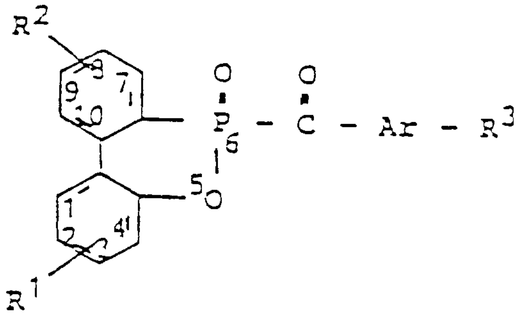

(I)

dans laquelle chacun des radicaux $R^1$, $R^2$ ou $R^3$ peut être présent une ou plusieurs fois, et $R^1$, $R^2$ ou $R^3$ représentent chacun un halogène ayant un nombre atomique de 9 à 35, alkyle ou alcoxy ayant chacun de 1 à 6 atomes de carbone, et Ar est un radical hydrocarboné aromatique ayant de 6 à 10 atomes de carbone.

**2.** Composés selon la revendication 1, caractérisés par au moins l'une des caractéristiques suivantes :
a) au moins l'un des radicaux $R^1$, $R^2$ et $R^3$ est le chlore, de préférence $R^1$, $R^2$ et $R^3$ contenant ensemble au pins deux atomes de chlore, dont au moins l'un représente $R^3$,
b) ils contiennent des radicaux alkyle ou alcoxy ayant chacun de 1 à 4 atomes de carbone, le radical alkyle étant de préférence le radical méthyle ou éthyle, et le radical alcoxy étant de préférence le radical méthoxy, et
c) ils ne contiennent au plus chacun qu'un radical $R^1$ et $R^2$ et de préférence aucun radical $R^1$ et $R^2$, et
d) ils contiennent au moins un radical $R^3$, de préférence sous forme d'un ou deux résidus en position ortho, et en outre éventuellement encore un radical en position para.

**3.** Composés selon les revendications 1 ou 2, caractérisés en ce que Ar désigne le radical benzyle.

**4.** Procédé pour préparer des composés selon l'une ou plusieurs des revendications 1 à 3, caractérisé en ce qu'on fait réagir un composé de formule II

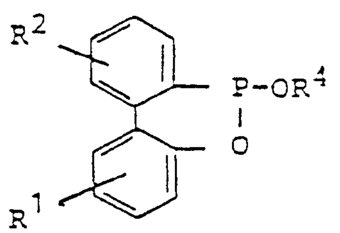

(II)

avec un chlorure d'acyle de formule Cl-CO-Ar-$R^3$ (III), $R^1$, $R^2$, $R^3$ et Ar ayant les significations données dans les revendications 1 à 3, et $R^4$ étant un radical alkyle, avantageusement ayant de 1 à 6 atomes de carbone, et de préférence le radical méthyle ou éthyle.

**5.** Procédé selon la revendication 4, caractérisé en ce qu on travaille à des températures de 50 à 150 °C, de préférence de 70 à 130 °C et en particulier de 80 à 120 °C.

**6.** Utilisation de composés selon l'une ou plusieurs des revendications 1 à 3, ou de ceux qui ont été obtenus par le procédé selon les revendications 4 ou 5, en tant que photoamorceurs dans des compositions photopolymérisables.

**7.** Forme de réalisation selon la revendication 6, caractérisée en ce que les composés sont présents en une quantité de 0,001 à 20, avantageusement de 0,01 à 15 et de préférence de 0,1 à 5 % en poids par rapport au poids de la composition photopolymérisable.

**8.** Forme de réalisation selon les revendications 7 ou 8, caractérisée en ce que les compositions se présentent sous la forme de revêtements pouvant durcir sous l'effet d'un rayonnement, en particulier de vernis transparent ou de vernis pigmentés ou d'encres d'imprimerie, ou encore de masses de remplissage, de masses à spatuler ou de masses d'étanchéité, qui contiennent les composés selon la revendication 1 selon une concentration de 0,001 à 20 et de préférence de 0,01 à 10 % en poids.

**9.** Forme de réalisation selon les revendications 7, 8 ou 9, caractérisée en ce que les composés selon la revendication 1 sont utilisés en combinaison avec d'autres photoamorceurs, notamment des cétones aromatiques et/ou des dérivés de la thioxanthone, avantageusement selon une proportion pondérale de 0,5:1 à 30:1, de préférence de 0,8:1 à 10:1 et en particulier de 1:1 à 3:1, la teneur totale en photoamorceurs étant avantageusement de 1 à 20 % en poids par rapport au poids total de la composition polymérisable totale.

**10.** Forme de réalisation selon la revendication 9, caractérisée en ce qu'on utilise aussi en tant qu'accélérateur encore au moins un composé aminé secondaire et/ou tertiaire.

**11.** Alcoxy-6 (6H)-dibenzo[c,e][1,2]oxaphosphorines de formule II

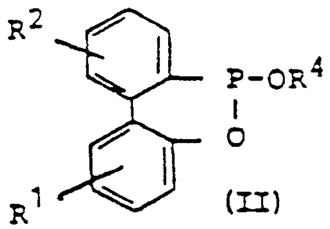

(II)

(II)

dans laquelle $R^1$ et $R^2$ ont les significations données dans les revendications 1 à 3, et $R^4$ est un radical alkyle ayant de 1 à 6 atomes de carbone, au moins un radical $R^1$ étant cependant un halogène.